# EUROPEAN PATENT SPECIFICATION

(11) **EP 2 105 954 B1**
(45) Date of publication and mention of the grant of the patent: **21.03.2012**
(21) Application number: 09155898.1
(22) Date of filing: 23.03.2009
(51) Int. Cl.: H01L 21/322, H01L 27/146, H01L 27/12

(54) **Method of manufacturing a backside illumination solid imaging device**
Verfahren zur Herstellung einer rückseitenbeleuchtete Festkörperbildvorrichtung
Procédé de fabrication d'un dispositif d'imagerie solide de type à rétro-éclairage

(30) Priority: 25.03.2008 JP 2008077756; 20.05.2008 JP 2008131699
(43) Date of publication of application: 30.09.2009
(73) Proprietor: SUMCO CORPORATION, Tokyo 105-8634 (JP)
(72) Inventor: Kurita, Kazunari, Tokyo 105-8634 (JP); Omote, Suichi, Tokyo 105-8634 (JP)
(74) Representative: Cabinet Plasseraud

(56) References cited:
- EP-A- 1 612 863
- EP-A- 1 677 344
- EP-A- 1 833 100
- EP-A- 1 883 104
- WO-A-2008/029918
- JP-A- 8 321 509
- US-A1- 2006 175 613
- US-A1- 2006 197 007
- US-A1- 2007 020 893

## Description

### BACKGROUND OF THE INVENTION

### 1. Field of the Invention

This invention relates to a production method of a backside illumination type solid imaging device.

### 2. Description of the Related Art

Recently, a high-performance solid imaging device using a semiconductor is mounted onto a mobile phone, a digital video camera or the like, and hence the performances such as number of pixcels and the like are dramatically improved. As the performance to be expected in the usual solid imaging device are high-quality pixels and ability of taking moving images, and further miniaturization is required. In order to take moving images, it is required to combine a high-speed computing device with a memory device, and hence a CMOS image sensor allowing System on Chip (SoC) easily is used and the downsizing of the CMOS image sensor is developed.

With the downsizing of the CMOS image sensor, however, there is caused a problem that an aperture ratio of a photo diode as a photoelectric conversion device is inevitably reduced to lower a quantum efficiency of the photoelectric conversion device, which makes it difficult to improve S/N ratio of imaging data. Therefore, it is attempted to conduct a method for increasing incident light quantity by inserting an inner lens into a front side of the photoelectric conversion device, or the like. However, the remarkable improvement of S/N ratio can not been realized.

In order to increase the incident light quantity to improve S/N ratio of the image data, therefore, it is attempted to feed the incident light from a backside of the photoelectric conversion device. The greatest merit of the light incidence from the backside of the device lies in a point that restriction due to reflection or diffraction on the surface of the device or the light receiving area of the device is eliminated as compared with the light incidence from the front side. On the other hand, when the light is entered from the backside, the absorption of the light through a silicon wafer as a substrate of the photoelectric conversion device must be suppressed, and hence the thickness of the solid imaging device as a whole is required to be less than 50 µm. As a result, the working and handling of the solid imaging device become difficult, causing a problem of extremely low productivity.

For the purpose of resolving the above technical problems, there are mentioned solid imaging devices as disclosed, for example, in JP-A-2007-13089 and JP-A-2007-59755.

When using the production method of the solid imaging device in JP-A-2007-13089, it is possible to produce a backside illumination type CMOS solid imaging device having a structure that electrodes are taken out from a surface opposite to the illuminated surface relatively simply and easily.

On the other hand, when using the production method of the solid imaging device in JP-A-2007-59755, it is possible to conduct the processing of a thinned solid imaging device with a high accuracy.

In the solid imaging devices of JP-A-2007-13089 and JP-A-2007-59755, however, the gettering ability of the substrate (wafer) is low, so that there is problems that white defects occur and that heavy metal pollution occurs in the production process. Therefore, it is required to solve these problems in order to put the backside illumination type solid imaging device into practical use.

EP 1 677 344 A1 discloses processes for producing high-resistance silicon wafers, epitaxial wafers and SOI wafers usable in high-frequency communication devices and analog/digital hybrid devices. EP 1 883 104 A1 discloses a method for manufacturing bonded SOI wafers which can remove heavy metal impurities. US 2006/0197007 A1 discloses a back-illuminated type CMOS solid-state image pickup device. JP 08 321509 A discloses a manufacturing method designed to improve crystal defects and gettering effect of metal impurities by laminating a carbon-doped polycrystalline silicon layer on a single-crystal silicon substrate.

### SUMMARY OF THE INVENTION

It is, therefore, an object of the invention to provide a production method of a backside illumination type solid imaging device capable of effectively suppressing the occurrence of white defects and heavy metal pollution.

In order to achieve the above object, the present invention concerns a method according to claim 1.

### BRIEF DESCRIPTION OF THE DRAWINGS

The invention will be described with reference to the accompanying drawings, wherein:
FIG. 1 is a schematically cross-sectional view of a wafer for backside illumination type solid imaging device;
FIG. 2 is a schematically cross-sectional view of a backside illumination type solid imaging device;
FIG 3 is a schematically cross-sectional view of a wafer for active layer used in a wafer for backside illumination type solid imaging device ; and
FIG. 4 is a schematic flow chart of steps for producing a wafer for backside illumination type solid imaging device, wherein (a) is a wafer for active layer, (b) is a wafer for active layer provided with an insulating film formed thereon, (c) is a wafer for support substrate, (d) is a state of bonding a wafer for active layer to a wafer for support substrate, and (e) is a wafer for backside illumination type solid imaging device.

### DESCRIPTION OF THE PREFFERRED EXAMPLES

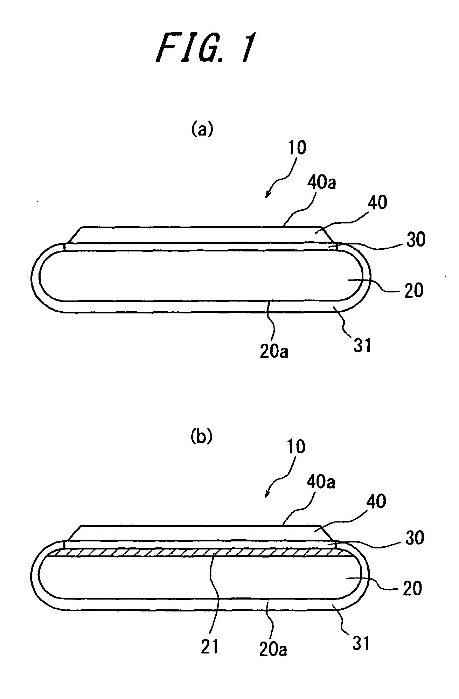

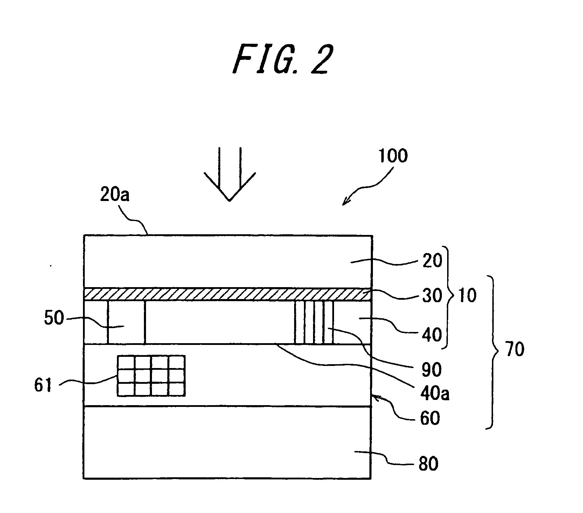

Each of FIGS. 1(a) and 1(b) is a schematically cross-sectional view of a wafer for backside illumination type solid imaging device. Further, FIG 2 is a schematically cross-sectional view of a backside illumination type solid imaging device using the wafer for backside illumination type solid imaging device shown FIG 1(a) after processing thereof.

The wafer 10 for backside illumination type solid imaging device is a wafer 10 used in a backside illumination type solid imaging device 100 having a plurality of pixels 70 inclusive of a photoelectric conversion device 50 and a charge transfer transistor 60 at its a front surface side 40a and a light receiving surface at its backside 20a as shown in FIG 2.

The wafer 10 for backside illumination type solid imaging device is mainly characterized to be a SOI wafer 10 obtained by forming a given active layer 40 on a support substrate 20 made of C-containing n-type semiconductor material through an insulating layer 30 as shown in FIG. 1(a). By adopting such a structure, the C atoms are taken into positions between silicon lattices in the support substrate 20 to promote precipitation of an oxygen-containing substance in a heat treatment step for producing the solid imaging device, and thus the oxygen precipitates can serve as a gettering site. As a result, when the wafer 10 is used for the backside illumination type solid imaging device 100, the occurrence of white defects and heavy metal pollution can be effectively suppressed as compared with the conventional imaging devices.

The components in the wafer 10 for backside illumination type solid imaging device will be described below.

### (Support substrate)

The support substrate 20 is a substrate made of n-type or P-type semiconductor material, which is required to contain a given amount of C for developing the above effect. The semiconductor used in the support substrate 20 is not particularly limited as long as it satisfies the above properties. From a point that the substrate can be obtained relatively easily, there are used a substrate 20 made of silicon material containing an elementary atom of the Group 15 such as P, As, Sb or the like for n-type.

Also, as the support substrate 20 is preferably used a n-type carbon-containing substrate in view of strengthening the gettering ability. Further, the support substrate 20 is preferable to have a specific resistance of 0.5 to 100 Ω·cm.

Moreover, the C concentration of the support substrate 20 is preferable to be within a range of 1.0x10¹⁶ to 1.0x10¹⁷ atoms/cm³. When the C concentration is less than 1.0x10¹⁶ atoms/cm³, there is a fear that the gettering ability can not be developed sufficiently and the occurrence of white defects and heavy metal pollution can not be sufficiently suppressed, while when it exceeds 1.0x10¹⁷ atoms/cm³, the size of the oxygen precipitates is less than 50 nm and hence strain energy capable of gettering heavy metal can not be retained.

Since the wafer 10 is used in the backside illumination type solid imaging device 100, when it is used as a device as shown in FIG 2, the support substrate 20 can be processed until the thickness becomes not more than 20 µm. The thickness of the support substrate in the conventional wafer used for the backside illumination type solid imaging devices is 40 to 150 mm, whilst in this example , the thickness may be made to not more than 20 µm because the thickened SIO structure is used.

### (Insulating layer)

Since the wafer 10 for backside illumination type solid imaging device is SOI, an insulating layer 30 is formed on the support substrate 20. The formation of the insulating layer 30 brings about the electric insulation between the support substrate 20 and the active layer 40, enabling smaller parasitic capacitance and speedup of the device. A kind of the insulating layer 30 is not particularly limited as long as it is an insulating film, but is preferable to be a silicon oxide film (SiO₂) from a point that it can be obtained relatively easily.

Although the method for forming the insulating layer 30 will be concretely described later, since it is bonded to either the support substrate 20 or the active layer 40 (the support substrate 20 in the case of FIG. 1(a)) at a state that the periphery thereof is oxidized as a whole, as shown in FIG. 1(a), a residual oxide film 31 remains on the insulating layer 30 at a bonding interface of the wafer 10 for backside illumination type solid imaging device but also around the support substrate 20. When the wafer 10 is used in the imaging device 100, since it is subjected to the processing, the residual oxide film 31 is already removed.

### (Active layer)

The active layer 40 is a layer formed on the insulating layer 30. It is a device layer arranged with the photoelectric conversion device 50 and the charge transfer transistor 60 as shown in FIG 2. Moreover, it is preferably formed by bonding a wafer for active layer to a wafer for support substrate from a viewpoint that SOI being less in the defects and having the active layer 40 usable for an imaging device can be obtained simply. The detail of the production method will be described later.

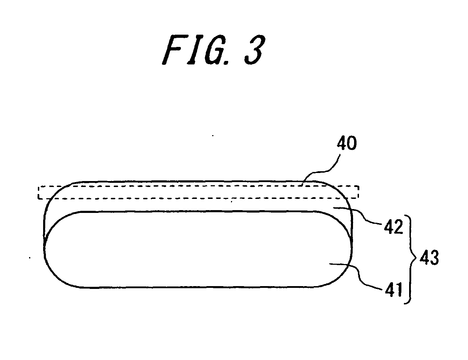

In FIG. 3 is schematically shown a cross-section of an epitaxial wafer as a wafer for active layer. The active layer 40 is preferable to be an epitaxial layer 42 of Si formed on a substrate 41 for active layer made of C-containing n-type or p-type semiconductor material as shown in FIG 3. The epitaxial layer 42 formed on the substrate 41 for active layer made of C-containing n-type or p-type semiconductor material can provide the active layer 40 being less in the defects and having a high quality owing to the gettering effect of the C-containing substrate 41 for active layer. Therefore, when the active layer 40 is formed on the insulating layer 30, the effect of suppressing the occurrence of white defects and heavy metal pollution can be further improved in the solid imaging device 100.

Furthermore, the C concentration in the substrate for active layer is preferable to be within a range of 1.0x10¹⁶ to 1.0x10¹⁷ atoms/cm³. When the C concentration is less than 1.0x10¹⁶ atoms/cm³ likewise the case of the support substrate 20, there is a fear that the gettering ability can not be sufficiently developed and hence the white defects and heavy metal pollution generated in the active layer 40 can not be sufficiently suppressed, while when it exceeds 1.0x10¹⁷ atoms/cm³, the size of the oxygen precipitates becomes minimal and it is difficult to retain strain energy required for the gettering and hence there is a fear that the gettering ability lowers.

Moreover, it is preferable that C atoms contained in the support substrate 20 are existent as a high carbon concentration region 21 just beneath an interface with the insulating layer 30 as shown in FIG. 1(b). The high carbon concentration region 21 means a region having locally a large C content wherein the C concentration in the support substrate 20 is within a range of 1.0x10¹⁶ to 1.0x10¹⁷ atoms/cm³. Since the high carbon concentration region 21 serves as a gettering sink effectively, the effect of suppressing the occurrence of white defects and heavy metal pollution can be further improved.

Moreover, as shown in FIG. 2, the backside illumination type solid imaging device 100 can be prepared when an embedded electrode (not shown) for transferring image data is connected to the pixels 70 including the wafer 10 for backside illumination type solid imaging device 100. By the gettering effect of the wafer 10 for backside illumination type solid imaging device 100, it is made possible to provide the backside illumination type solid imaging device 100 being excellent in the ability of suppressing the occurrence of white defects and heavy metal pollution as compared with the conventional backside illumination type solid imaging device. In FIG 2, an embedded wiring 61 is disposed in the charge transfer transistor 60 and further a substrate 80 is arranged as a base for the pixels 70.

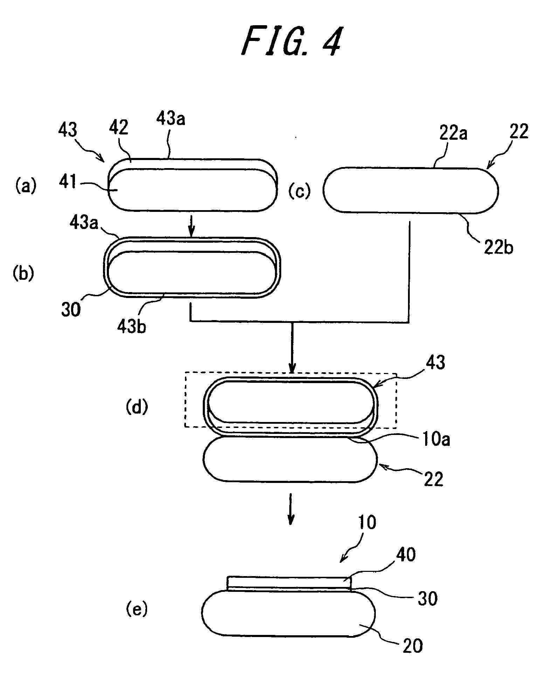

Subsequently, the method for producing the wafer for backside illumination type solid imaging device will be described with reference to the accompanying drawings. FIG 4 is a flow chart for explaining the method for producing the wafer for backside illumination type solid imaging device.

As shown in FIG 4, the wafer 10 for backside illumination type solid imaging device is characterized by forming an insulating layer 30 having a thickness of about 0.1 to 100 nm on a surface of a wafer 43 for active layer 43 (FIG. 4(a)), which is an epitaxial wafer obtained by forming an epitaxial film of Si on a substrate for active layer made of n-type or p-type semiconductor material preferably having a C concentration of 1.0x10¹⁶ to 1.0x10¹⁷ atoms/cm³, through a treatment such as thermal oxidation or the like (FIG. 4 (b)), and thereafter bonding a wafer 22 for support substrate made of n-type semiconductor material containing C (preferably C concentration: 1.0×10¹⁶ to 1.0×10¹⁷ atoms/cm³) (FIG 4(c)) to the wafer 43 for active layer 43 through the insulating layer 30 (FIG 4(d)), and then thinning the wafer 43 for active layer 43 to form SOI wafer 10 (FIG 4(e)).

When the wafer 10 for backside illumination type solid imaging device is formed by the above method, the C atoms in the support substrate 20 are taken into positions between silicon lattices in the support substrate 20 to promote the precipitation of oxygen-containing substance in a heat treatment step for the production of the solid imaging device, and thus the oxygen precipitates can serve as a gettering site. As a result, when the wafer 10 is used for the backside illumination type solid imaging device 100, the occurrence of white defects and heavy metal pollution can be effectively suppressed as compared with the conventional imaging devices.

In FIG. 4, the insulating layer 30 is formed by subjecting the wafer 43 for active layer to a thermal oxidation treatment . In fact, it is also possible to form the insulating layer 30 on the wafer 22 for support substrate and then bond to the wafer 43.

As a method of including a given amount of C into the wafer 22 for support substrate and the wafer 43 for active layer, there are a method of doping a silicon substrate with C atoms, a method of implanting ions and so on, whereby it is made possible to include the C atoms into the wafer 22 for support substrate.

Also, O atoms can be included into the wafer 22 for support substrate and the wafer 43 for active layer. The inclusion of the O atoms can effectively suppress the diffusion of the C atoms included for the gettering effect into the active layer.

Furthermore, it is preferable that each of the wafer 43 for support substrate and the wafer 22 for active layer is subjected to a heat treatment at 600-800°C before the bonding of the wafers 22 and 43. Since the precipitation of oxygen is promoted by this heat treatment, it is possible to form high-density oxygen precipitates.

Moreover, it is preferable that the bonding is conducted after a given organic substance is adsorbed on bonding surfaces 22a, 43a of the wafer 22 for support substrate and/or the wafer 43 for active layer 43. When the bonding is conducted after the adsorption of the organic substance on the bonding surface(s) (FIG. 4 (d)), the organic substance forms the high carbon concentration region 21 at the bonding interface 10a by the heat treatment in the bonding, and hence the further improvement of the gettering ability is expected in the wafer 10.

As the organic substance is preferable an organic carbon compound such as N-methyl pyrrolidone, polyvinyl pyrrolidone or the like. By using such an organic substance can be simply formed the high carbon concentration region 21.

In the production method, it is preferable that a polysilicon film (not shown) is formed on surfaces 22b, 43b opposite to the bonding surfaces 22a, 43a of the wafer 22 for support substrate and the wafer 43 for active layer, respectively. The resulting polysilicon film serves as a gettering sink, which is expected to further improve the gettering effect.

A wafer for backside illumination type solid imaging device is prepared as a sample and its performances are evaluated as described below.

### (Example 1)

As shown in FIG. 4, there is provided an epitaxial wafer obtained by forming an epitaxial film of Si on a substrate 41 for active layer made of C-containing n-type silicon (C concentration: 1.0×10¹⁶ atoms/cm³, specific resistance: 10 Ω·cm) through a CVD method as a wafer 43 for active layer (FIG. 4(a)), and then an insulating layer 30 having a thickness of 0.1 µm is formed on the surface thereof by a thermal oxidation treatment (FIG. 4(b)). Thereafter, a wafer 22 for support substrate of n-type silicon made of C-containing n-type semiconductor material (C concentration: 1.0×10¹⁶ atoms/cm³, specific resistance: 10 Ω·cm) (FIG. 4(c)) is bonded to the wafer 43 for active layer through the insulating layer 30 (FIG. 4(d)), and then the wafer 43 for active layer is thinned by polishing and chemical etching to prepare a sample of a wafer 10 for backside illumination type solid imaging device as a SOI wafer having the given support substrate 20, insulating layer 30 and active layer 40 (FIG. 4 (e)).

### (Example 2)

A sample of a wafer 10 for backside illumination type solid imaging device is prepared in the same steps as in Example 1 (FIGS. 4(a) to (e)) except that an organic substance, N-methyl pyrrolidone is adsorbed on a bonding surface 22a of the wafer 22 for support substrate 22 before the step of bonding the wafer 22 for support substrate to the wafer 43 for active layer (FIG 4(d)) and then the bonding and heat treatment are conducted to form a high carbon concentration region 21 on a bonding interface 10a.

### (Example 3)

A sample of a wafer 10 for backside illumination type solid imaging device is prepared in the same steps as in Example 1 (FIGS. 4(a) to (e)) except that a polysilicon film (not shown) is formed on surfaces 22b, 43b opposite to the bonding surfaces 22a, 43a of the wafer 22 for support substrate and the wafer 43 for active layer, respectively.

### (Example 4)

As shown in FIG. 4, there is provided an epitaxial wafer obtained by forming an epitaxial film of Si on a substrate 41 for active layer made of C-containing p-type silicon (C concentration: 1.0×10¹⁵ atoms/cm³, specific resistance: 10 mΩ·cm) through a CVD method as a wafer 43 for active layer (FIG 4(a)), and then an insulating layer 30 having a thickness of 0.1 µm is formed on the surface thereof by a thermal oxidation treatment (FIG. 4(b)). Thereafter, a wafer 22 for support substrate made of C-containing p-type semiconductor material (C concentration: 1.0×10¹⁵ atoms/cm³, specific resistance: 10 mΩ·cm) (FIG. 4(c)) is bonded to the wafer 43 for active layer through the insulating layer 30 (FIG. 4(d)), and then the wafer 43 for active layer is thinned by polishing and chemical etching to prepare a sample of a wafer 10 for backside illumination type solid imaging device as a SOI wafer having the given support substrate 20, insulating layer 30 and active layer 40 (FIG. 4 (e)).

### (Comparative Example)

A sample of a wafer 10 for backside illumination type solid imaging device is prepared as a usual bonded SOI formed by bonding a wafer for support substrate made of Si (not including C) to a wafer for active layer made of Si through an oxide film and then removing a part of the wafer for active layer.

### (Evaluation method)

Each sample prepared in the above examples and comparative example is evaluated by the following evaluation methods.

### (1) White defects

A backside illumination type solid imaging device is prepared by using each sample prepared in the above examples and comparative example, and thereafter the dark leakage current of a photodiode in the backside illumination type solid imaging device is measured and converted to pixel data (number data of white defects) with a semiconductor parameter analyzing apparatus, whereby the number of white defects per unit area (1 cm²) is counted to evaluate the suppression on the occurrence of white defects. The evaluation standard is shown below, and the measured results and evaluation results are shown in Table 1.
⊚ : not more than 5
○ : more than 5 but not more than 50
× : more than 50

### (2) Heavy metal pollution

The defect density (number/cm²) on the surface of each obtained sample is measured by soiling the sample surface with nickel (1.0×10¹² atoms/cm²) by a spin coat soiling method and thereafter subjecting to a heat treatment at 900°C for I hour and then selectively etching the surface of the sample. The evaluation standard is shown below, and the measured results and evaluation results are shown in Table 1.
⊚ : not more than 5
○ : more than 5 but not more than 50
× :more than 50

**Table 1**

| | C content (atoms/cm³) | | Presence or absence of high carbon concentration region | Presence or absence of polysilicon film | Evaluation results | |
|---|---|---|---|---|---|---|
| | Support substrate | Active layer | | | White defects | Heavy metal pollution |
| | | | | | Evaluation | Evaluation |
| Example 1 | 1.00E+16 | 1.00E+16 | - | - | ○ | c |
| Example 2 | 5.00E+16 | 5.00E+16 | Presence | - | ⊚ | ⊚ |
| Example 3 | 7.00E+16 | 7.00E+16 | - | Presence | ⊚ | ⊚ |
| Example 4 | 1.00E+15 | 1.00E+15 | - | - | ○ | ○ |
| Comparative Example | - | - | - | - | × | × |

As seen from the results of Table 1, Examples 1 to 4 can suppress the occurrence of white defects and heavy metal pollution as compared with the comparative example. Furthermore, it is found that Examples 2 and 3 are high in the gettering ability and further higher in the effect of suppressing the occurrence of white defect and heavy metal pollution as compared to Examples 1 and 4.

According to the invention, it is possible to provide a production method of a backside illumination type solid imaging device capable of suppressing the occurrence of white defects and heavy metal pollution effectively.

## Claims

1. A method of producing a backside illumination type solid imaging device (100), **characterized in that** it comprises:
bonding a wafer (22) for support substrate made of C-containing n-type semiconductor material, having a C concentration within the range of 1.0x10¹⁶ to 1.0x10¹⁷ atoms/cm³; to a wafer (43) for active layer through an insulating layer (30) after an organic substance, selected from the group consisting of N-methyl pyrrolidone and polyvinyl pyrrolidone, is adsorbed on a bonding surface (22a, 43a) of at least one of the wafer (22) for support substrate and the insulating layer (30) on the wafer (43) for active layer; the wafer for active layer being an epitaxial wafer obtained by forming an epitaxial film of Si on a substrate for active layer made of C-containing n-type semiconductor material;
subjecting the bonding wafers to a heat treatment such that the organic substance forms a high carbon concentration region (21) at a bonding interface (10a) between the insulating layer (30) and the wafer (22) for support substrate;
thinning the wafer (43) for active layer to obtain an active layer;
providing the active layer (40), at a front surface side (40a) thereof, with a photoelectric conversion device (50) and a charge transfer transistor (60);
providing an embedded wiring (61) such that the embedded wiring is disposed in the charge transfer transistor (60); and
adapting a back surface side (20a) of the wafer (22) for support substrate in such a way that the support substrate (20) has a thickness of not more than 20 µm, thereby the back surface functioning as a light receiving surface.

## Patentansprüche

1. Verfahren zum Produzieren einer festen Bildgebungsvorrichtung mit Rückseitenbeleuchtung (100), **dadurch gekennzeichnet, dass** sie umfasst:
- Bonden eines Wafers (22) für ein Trägersubstrat, hergestellt aus C enthaltendem n-Halbleitermaterial mit einer C-Konzentration innerhalb des Bereichs von 1,0x10¹⁶ bis 1,0x10¹⁷ Atomen/cm³, an einen Wafer (43) für eine aktive Schicht durch eine isolierende Schicht (30), nachdem eine organische Substanz, ausgewählt aus der Gruppe bestehend aus N-Methyl-Pyrrolidon, Polyvinyl-Pyrrolidon, an einer Bonding-Oberfläche (22a, 43a) mindestens eines des Wafers (22) für das Trägersubstrat und der isolierenden Schicht (30) auf dem Wafer (43) für die aktive Schicht adsorbiert ist, wobei der Wafer für die aktive Schicht ein Epitaxiewafer ist, erhalten durch Bilden eines Epitaxiefilms aus Si auf einem Substrat für die aktive Schicht, hergestellt aus C enthaltendem n-Halbleitermaterial;
- Aussetzen der Bonding-Wafer einer Wärmebehandlung derart, dass die organische Substanz eine Region hoher Kohlenstoffkonzentration (21) an einer Bonding-Grenzfläche (10a) zwischen der isolierenden Schicht (30) und dem Wafer (22) für das Trägersubstrat bildet,
- Dünnen des Wafers (43) für die aktive Schicht, um eine aktive Schicht zu erhalten;
- Versehen der aktiven Schicht (40), an einer vorderen Oberflächenseite (40a) davon, mit einer fotoelektrischen Umwandlungsvorrichtung (50) und einem Ladungsübertragungstransistor (60);
- Bereitstellen einer eingebetteten Verdrahtung (61) derart, dass die eingebettete Verdrahtung in dem Ladungsübertragungstransistor (60) angeordnet ist; und
- Anpassen einer hinteren Oberflächenseite (20a) des Wafers (22) für das Trägersubstrat in einer derartigen Weise, dass das Trägersubstrat (20) eine Dicke von nicht mehr als 20 µm aufweist, wodurch die hintere Oberfläche als eine Licht empfangende Oberfläche funktioniert.

## Revendications

1. Procédé de fabrication d'un dispositif d'imagerie solide à rétro-éclairage (100), **caractérisé en ce qu'**il comprend :
la liaison d'une tranche (22) pour substrat de support composé d'un matériau semi-conducteur de type n contenant du carbone, ayant une concentration de carbone dans la plage de 1,0x10¹⁶ à 1,0x10¹⁷ atomes/cm³, avec une tranche (43) pour couche active à travers une couche isolante (30) après qu'une substance organique, sélectionnée dans le groupe constitué de la N-méthyl-pyrrolidone et de la pyrrolidone de polyvinyle, a été absorbée sur une surface de liaison (22a, 43a) d'au moins une de la tranche (22) pour substrat de support et de la couche isolante (30) sur la tranche (43) pour couche active ; la tranche pour couche active étant une tranche épitaxiale obtenue en formant un film épitaxial de Si sur un substrat pour couche active constitué d'un matériau semi-conducteur de type n contenant du carbone,
la soumission des tranches de liaison à un traitement thermique de sorte que la substance organique forme une région de haute concentration de carbone (21) au niveau d'une interface de liaison (10a) entre la couche isolante (30) et la tranche (22) pour substrat de support,
l'amincissement de la tranche (43) pour couche active pour obtenir une couche active ;
la fourniture sur la couche active (40), au niveau d'un côté de surface frontale (40a) de celle-ci, d'un dispositif de conversion photoélectrique (50) et d'un transistor de transfert de charge (60) ;
la fourniture d'un câblage incorporé (61) de sorte que le câblage incorporé soit disposé dans le transistor de transfert de charge (60) ; et
l'adaptation d'un côté de surface arrière (20a) de la tranche (22) pour substrat de support de telle sorte que le substrat de support (20) ait une épaisseur non supérieure à 20 µm, la surface arrière fonctionnant ainsi comme une surface de réception de lumière.
